(19) Europäisches Patentamt
European Patent Office
Office européen des brevets

(11) **EP 3 627 227 A1**

(12) **EUROPEAN PATENT APPLICATION**

(43) Date of publication:
**25.03.2020  Bulletin 2020/13**

(51) Int Cl.:
**G03F 7/20** (2006.01)   **B29C 64/393** (2017.01)

(21) Application number: **18196384.4**

(22) Date of filing: **24.09.2018**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME**<br>Designated Validation States:<br>**KH MA MD TN** | (71) Applicant: **Stichting Nederlandse Wetenschappelijk Onderzoek Instituten**<br>**3527 JP Utrecht (NL)**<br><br>(72) Inventor: **Kostenko, Alexander**<br>**3527 JP Utrecht (NL)**<br><br>(74) Representative: **De Vries & Metman**<br>**Overschiestraat 180**<br>**1062 XK Amsterdam (NL)** |

(54) **CONTROLLED POLYMERIZATION OF A TARGET ZONE IN A PHOTOPOLYMERIZABLE MEDIUM**

(57)     A method is described for controlled polymerization of a target zone in a photopolymerizable medium wherein the method comprises a processor connectable to an exposure system for illuminating a target zone in a photopolymerizable medium receiving a 3D data representation of a 3D model of an object and using the 3D model to determine a volume of the target zone, the volume being shaped according to the 3D model; the processor determining a target energy field $E_0$ defining an energy for volume elements in the medium that is needed to achieve polymerization inside the target zone, the determining being based on a model of the polymerization process in the medium; the processor using the target energy field $E_0$ and a light propagation model $\mathcal{M}$ to compute a solution $I_o$ for the equation $E_0 = t \cdot \mathcal{M} \cdot I_o$, wherein $I_o$ is a direction-dependent illumination field needed for achieving energy deposition in the medium according to the target energy field $E_0$ and t is the exposure time; and, the processor controlling the exposure system based on the direction-dependent illumination field $I_o$, the exposure including generating a plurality of direction-dependent illumination beams to deposit energy within the target zone according to the target energy field $E_0$.

FIG. 1

EP 3 627 227 A1

**Description**

Field of the invention

The invention relates to controlled polymerization of a target zone in a photopolymerizable medium, and, in particular, though not exclusively, to methods and systems for determining an illumination intensity for polymerization of a target zone in a photopolymerizable medium and to methods and systems for forming a three-dimensional object by controlled polymerization of a target zone in a photopolymerizable medium and to computer program products using such methods.

Background of the invention

During past decades, a large number of techniques were developed for the generation of solid three-dimensional structures from liquid polymerizable media (photocurable resins). The underlying process involving a photocurable resin that can be polymerized when illuminated by electromagnetic radiation (typically ultra-violet, visible or infra-red light) is referred to as optical- or photolithography. Developments in the field of high-resolution photolithography include Resolution Augmentation through Photoinduced Deactivation (RAPID), PhotoInhibited Super Resolution (PInSR) and multi-colour photolithography.

A number of approaches were developed for production of three-dimensional objects, including the standard stereo lithography or variations thereof, such as Projection Stereo Lithography (PSL) and Continuous liquid interface printing (CLIP). In these techniques, three-dimensional structures are fabricated through sequential generation of thin two-dimensional layers. Techniques that allow initiation of the photopolymerization reaction in the volume instead of a layer-by-layer process were, so far, limited to holographic lithography and multiphoton polymerization - approaches that are suitable for generation of structures and patterns on a microscopic scale. Implementation of volumetric printing was proposed more than three decades ago, however, actual realizations of techniques that allow volumetric fabrication at macroscopic scale were only recently achieved.

For example, Shusteff1 et. al, describe in their article One-step volumetric additive manufacturing of complex polymer structures, Science Advances 8 Dec 2017, vol. 3, no. 12, a triple-beam holographic illumination technique enabling realization of macroscopic but relatively small ($\approx$ 1 cm), three-dimensional structures. However, accurate formation of a holographic image in a medium of certain properties (e.g. diffusion rates and concentrations of the reactive components) is a non-trivial exercise thereby limiting the maximum size, complexity and the spatial resolution of the produced object.

Hence, from the above it follows that there is a need in the art for improved methods and systems that enable the formation of three dimensional objects of considerably size based on controlled 3D exposure of a photopolymerization medium.

Summary of the invention

It is an objective of the invention to reduce or eliminate at least one of the drawbacks known in the prior art. The invention allows relaxation of resolution and size constraints as well as shape complexity constraints of current prior art systems for forming a complex 3D object based by controlled illumination of a photopolymerizable medium.

The methods and systems of the embodiments described in this application allow formation of an arbitrarily shaped polymer object of macroscopic dimensions, by means of a highly multi-directional illumination system (involving hundreds to thousands of directions of illumination) through controllable full-field illumination of the volume of the photopolymerizable medium. The system may include a computer for receiving a 3D data representation configured to compute an optimal direction-dependent illumination field that upon incidence on the volume of the photopolymerizable medium leads to formation of a polymerized solid object within the boundaries of the target polymerization zone.

In an aspect, the invention relates to a method of controlled polymerization of a target zone in a photopolymerizable medium wherein the method may comprise: a processor connectable to an exposure system for illuminating a target zone in a photopolymerizable medium receiving a data representation of a 3D model of an object and using the 3D model to determine volume elements of the target zone, the volume defined by the volume elements in the medium being shaped according to the 3D model; the processor determining a target energy field $E_0$, the target energy field $E_0$ defining an energy to be absorbed by the volume elements of of the target zone to achieve polymerization inside the target zone, the determining by the processor being based on a model, preferably a reaction kinetic model or empirical model, of the polymerization process in the medium; the processor computing a direction-dependent optimal illumination field $I_o$ for depositing within an exposure time t the target energy field $E_0$ in the volume elements of the medium, the computing being based on a light propagation model $M$ configured to predict the deposited energy field $E$ in an attenuating medium, the deposited energy field $E$ being generated upon exposure of the volume elements of the target zone to the direction-dependent illumination field $I$ during the exposure time $t$; and, the processor controlling the exposure system based on the direction-dependent illumination field $I_o$, the exposure including generating a plurality of direction-dependent illumination beams to deposit energy within the volume elements of the medium according to the target energy field $E_0$.

Hence, light propagation model $\mathcal{M}$ (of any suitable type, linear of non-linear) that models the deposited energy field E generated upon exposure of the medium to a direction-dependent illumination field I during time t, may be used to compute an optimal illumination field $I_0$ for example by minimization of a difference (or any algorithm based on minimization or maximization of a relevant objective function) between the deposited energy field E and the target energy field $E_0$ (where the target energy field $E_0$ may be determined statically or dynamically during the exposure of the medium). Hence, the target energy field $E_0$ may be used by the processor to determine a direction-dependent illumination field $I_0$ and an exposure time $t$ for each wavelength and each direction of illumination achievable within the illumination system. The illumination intensity and the exposure time may be selected to sustain and control the polymerization reaction within an accurately defined target zone that is shaped according to the 3D model. The processor may use the direction-dependent illumination intensities and exposure times (for each wavelength) to control a rotatable and/or movable illumination system so that in the target zone an object is formed through photopolymerization that matches the 3D model defined by the 3D data representation.

The processor may determine a solution of the illumination intensity based on a model wherein the energy deposition is described in a weakly attenuating medium. For a weakly attenuating medium, the solution may be computed analytically. Otherwise an iterative solver may be used to determine a solution using a model wherein energy deposition is described for a significantly attenuating medium.

In an embodiment, the computing may further include: determining a solution $I_o$ for a system of equations of the type $E_0 = t \cdot \mathcal{M} \cdot I_o$, preferably the light propagation model $\mathcal{M}$ being a model for predicting the deposited energy field E in a weakly attenuating medium.

In an embodiment, the computing may further include: iteratively determining an approximate solution $I_o$ based on the light propagation model $\mathcal{M}$, the computing including minimizing a difference between the target energy field $E_0$ and a deposited energy field $E$ predicted by the light propagation model $\mathcal{M}$, preferably the light propagation model $M$ being a model for predicting the deposited energy field $E$ in a medium attenuating medium.

In an embodiment, the medium may include a photo-activation compound, preferably a photo-initiator and, optionally, a photosensitizer, for activating polymerization of the medium and a photo-deactivation compound, preferably a photo-inhibitor, for deactivating polymerization in the medium.

In an embodiment, the computing a direction-dependent optimal illumination field $I_o$ may further include: computing at least a first illumination field $I_+$ associated with a first wavelength and a second illumination field $I_-$ associated with a second wavelength, the second wavelength being different from the first wavelength, the first illumination field $I_+$ being configured to deposit within an exposure time $t$ a first deposited energy $E_+$ in the volume elements of the medium for activating and maintaining polymerization in at least part of the target zone and the second illumination field $I_-$ being configured to deposit within an exposure time $t$ a second deposited energy $E_-$ in the volume elements of the medium for deactivation of polymerization in at least part of the target zone.

In case multiple photosensitive components are present in the medium, the target energy field may describe a linear combination of energies absorbed by each individual photosensitive component, provided that the given linear combination leads to initiation and sufficient advance of the polymerization reaction within the boundaries of the target zone and sufficient inhibition or deactivation of the polymerization reaction outside of the boundaries of the target zone.

In an embodiment, the analytical solution may include a Fourier filter applied to the Radon transform of the target deposited energy: $I_o = \frac{1}{\mu_+ t} \mathcal{F} \mathcal{R}[E_0]$.

In an embodiment, the system for illuminating a target zone may comprise a container enclosing a photopolymerizable medium and a rotatable and/or movable illumination system, the illumination system including an optical system comprising light sources and optical elements, a light modulating aperture and a support structure including motors and/or actuators configured to rotate and/or move the illumination system around the container while locally exposing the medium to light of at least one predetermined wavelength.

In an embodiment, the generating a plurality of direction-dependent illumination beams may include: the processor controlling a rotatable and/or movable illumination system, the illumination system including at least one pixelated spatial light modulator for generating the plurality of direction-dependent illumination beams.

In an embodiment, the method may further comprise: the processor controlling a detection system to measure the intensity of a part of the plurality of illumination beams that was not absorbed by the medium, preferably the processor using the intensity of the part of the plurality of illumination beams that was not absorbed to compute the absorptivity of

the medium $\mu$ during exposure.

In an embodiment, the method may further comprise: recomputing the direction-dependent optimal illumination field $I_o$ based on the target energy field $E_0$, the light propagation model $\mathcal{M}$ and the computed absorptivity $\mu$ of the medium; and, the processor controlling the exposure system based on the recomputed optimal direction-dependent illumination field $I_o$.

In an aspect, the invention may relate to a method of controlled polymerization of a target zone in a photopolymerizable medium. In an embodiment, the method may comprise: a processor connectable to an exposure system for illuminating a target zone in a photopolymerizable medium receiving a 3D data representation of a 3D model of an object and using the 3D model to determine a volume of the target zone, the volume being shaped according to the 3D model; the processor determining a target energy field $E_0$ defining an energy to be absorbed by volume elements in the medium to achieve polymerization inside the target zone, the determining being based on a model of the polymerization process in the medium; the processor using the target energy field $E_0$ and a light propagation model $\mathcal{M}$ for a weakly attenuating medium to compute a solution $I_o$, preferably an analytical, for the system of equations of the type: $E_0 = t \cdot \mathcal{M} \cdot I_o$, wherein $I_o$ is a direction-dependent illumination field needed for achieving energy deposition in the medium according to the target energy field $E_0$ and $t$ is the exposure time; and, the processor controlling the exposure system based on the direction-dependent illumination field $I_o$, the exposure including generating a plurality of direction-dependent illumination beams to deposit energy within the volume of the medium according to the target energy field $E_0$.

In another aspect, the invention may relate to a method of controlled polymerization of a target zone in a photopolymerizable medium wherein the method comprises one or more of the following steps: a processor connectable to an exposure system for illuminating a target zone in a photopolymerizable medium receiving a 3D data representation of a 3D model of an object and using the 3D model to determine a volume of the target zone, the volume being shaped according to the 3D model, the computer determining a target energy field $E_0$ defining an energy to absorbed by volume elements in the medium that is needed to achieve polymerization inside the target zone; the processor using the target energy field $E_0$ and a light propagation model $\mathcal{M}$ for an attenuating medium to iteratively compute an approximate solution $I_o$ for a system of equations of the type: $E_0 = t \cdot \mathcal{M} \cdot I_o$, through minimization of a difference between the target energy field $E_0$ and a deposited energy field $E$ predicted by the light propagation model $\mathcal{M}$ ; and, the computer controlling the exposure system based on the direction-dependent illumination field $I_o$, the exposure including generating a plurality of direction-dependent illumination beams to deposit energy within the target zone according to the target energy field $E_0$.

In an aspect, the invention may relate to an exposure system adapted to photopolymerize a target zone in a photopolymerizable medium wherein the system may comprise: a computer connectable to a rotatable illumination system for exposing the photopolymerizable medium, the computer comprising a computer readable storage medium having at least part of a program embodied therewith; and a processor, preferably a microprocessor, coupled to the computer readable storage medium, wherein responsive to executing the computer readable program code, the processor is configured to perform executable operations comprising: receiving a 3D data representation of a 3D model of an object and using the 3D model to determine a volume of the target zone, the volume being shaped according to the 3D model; determining a target energy field $E_0$ defining an energy to be absorbed by volume elements of the medium to achieve polymerization inside the target zone, the determining being based model of the polymerization process in the medium; using the target energy field $E_0$ and a light propagation model $\mathcal{M}$ for a weakly attenuating medium to compute an analytical solution $I_o$ for the equation $E_0 = t \cdot \mathcal{M} \cdot I_o$, wherein $I_o$ is a direction-dependent illumination field needed for achieving energy deposition in the medium according to the target energy field $E_0$ and $t$ is the exposure time; and, controlling the exposure system based on the direction-dependent illumination field $I_o$, the exposure including generating a plurality of direction-dependent illumination beams to deposit energy within the volume of the medium according to the target energy field $E_0$.

In an aspect, the invention may relate to an exposure system adapted to photopolymerize a target zone in a photopolymerizable medium wherein the system may include: a computer connectable to a rotatable illumination system for exposing the photopolymerizable medium, the computer comprising a computer readable storage medium having at least part of a program embodied therewith; and a processor, preferably a microprocessor, coupled to the computer readable storage medium, wherein responsive to executing the computer readable program code, the processor is configured to perform executable operations comprising: receiving a 3D data representation of a 3D model of an object and using the 3D model to determine a volume of the target zone, the volume being shaped according to the 3D model, the computer determining a target energy field $E_0$ defining an energy to be absorbed by volume elements of the medium to achieve polymerization inside the target zone; determining a direction-dependent illumination field $I_o$ needed for achieving energy deposition in the medium according to the target energy field $E_0$, the determining being based on using the target energy field $E_0$ and a light propagation model $\mathcal{M}$ for an attenuating medium to iteratively compute an

approximate solution $I_o$ for a system of equations of the type: $$E_0 = t \cdot \mathcal{M} \cdot I_o,$$ through minimization of a difference between the target energy field $E_0$ and a deposited energy field E predicted by the light propagation model $\mathcal{M}$ and, controlling the exposure system based on the direction-dependent illumination field $I_o$, the exposure including generating a plurality of direction-dependent illumination beams to deposit energy within the target zone according to the target energy field $E_0$.

In an embodiment, the medium may include a photo-activation compound, preferably a photo-initiator and, possibly, a photosensitizer, for activating polymerization of the medium and a photo-deactivation compound, preferably a photo-inhibitor, for deactivating polymerization in the medium, preferably the photo-activation being controlled by an illumination field of a certain wavelength and the photo-deactivation being controlled by an illumination field of a different wavelength.

In an embodiment, the system for illuminating a target zone may comprise a container enclosing a photopolymerizable medium and a rotatable and/or movable illumination system, the illumination system including an optical system comprising light sources and optical elements, a light modulating aperture and a support structure including motors and/or actuators configured to rotate and/or move the illumination system around the container while locally exposing the medium to light of at least one predetermined wavelength.

The exposure system described in this application may implement any (combination of) process steps described in this application.

The invention thus includes methods and systems for rapid three-dimensional fabrication, including a highly multidirectional illumination technique where a large number of illumination beams of variable intensity and are employed to concurrently initiate and/or inhibit a photopolymerization reaction in different parts of the volume of a photocurable resin allowing for an accurate confinement of the photopolymerization reaction within the boundaries of the target three-dimensional polymerization zone.

In order to control the initiation and inhibition of photopolymerization in the volume, more than one independent source of illumination potentially operating at different wavelengths can be used similarly to the multi-color lithography approach or similarly to the photoinduced deactivation approach.

The proposed multidirectional illumination technique may also be used in systems where inhibition of the photopolymerization reaction is not controlled via illumination but is associated with an agent that inhibits photopolymerization at an approximately constant rate in every part of the volume. The method relies on a light propagation model that allows to precompute optimal intensity for each direction of illumination. Such optimization is crucial to achieve correct focusing and deposition of the illumination energy in the volume and to facilitate high definition of the polymerization zone boundary.

The method can be used for rapid generation of an arbitrary three-dimensional solid shape inside a volume of a photopolymerizable medium through deposition of radiation (light) energy within a well-defined three-dimensional polymerization zone.

A polymerization zone with well-defined boundaries is generated due to interaction of the photopolymerizable medium with the illumination field formed by superposition of a large number of illumination beams modulated by light modulating apertures that surround the volume.

A configuration of each light modulating aperture is controlled by an optimization algorithm that finds a solution for the optimal illumination field. Two special cases of such algorithm (analytical and iterative) are described in this document.

The optimization algorithm attempts to solve a mathematical inversion problem for a system of equations that describes transport and deposition of radiation of a given wavelength in a medium with a given properties.

An analytical model may be used to compute a configuration of illumination leading to formation of a target polymerization zone in a medium with negligibly low or weak absorptivity. In case of a medium with medium to significant (substantial) absorptivity, an iterative solver is described that finds an approximate solution for the required illumination configuration.

The computational methods can be applied to different systems, e.g. a conventional photopolymerization system with passive inhibition where the whole volume absorbs some amount of 'background' radiation energy insufficient for complete polymerization due to the presence of inhibitor; while polymerization zone absorbs significantly higher amount of energy that is sufficient for polymerization; a system with active inhibition, where a photopolymerization reaction can be either initiated or inhibited (deactivated) through a controlled deposition of radiation energy inside and outside of the target polymerization zone; or, a system with projection-based illumination, where the illumination beams are considered to follow ray optics laws and systems with holographic illumination where wave properties of light are considered.

An exposure system with feedback may be implemented, wherein radiation transmitted through the volume is measured during the illumination and used to compute an update of the current medium absorptivity. Changes in absorptivity can be used for real-time correction of the optimal illumination. Absorptivity at multiple wavelengths in the infrared range can be measured in order to locally monitor the degree of polymerization in real time.

The invention may also relate to a computer program product comprising software code portions configured for, when run in the memory of a computer, executing the method steps as described in this application.

The invention will be further illustrated with reference to the attached drawings, which schematically will show embodiments according to the invention. It will be understood that the invention is not in any way restricted to these specific embodiments.

Brief description of the drawings

Fig. 1 depicts a schematic of a system for forming a 3D object using photopolymerization according to an embodiment of the invention;

Fig. 2 depicts part of a schematic of a system for forming a 3D object using photopolymerization according to an embodiment of the invention;

Fig. 3A-3E depict computed energy deposition based on a superposition of multiple illumination beams according to various embodiments of the invention;

Fig. 4A-4D depict computed energy deposition resulting from a superposition of multiple illumination beams that were precomputed and generated according to an analytical model valid for media with low absorptivity;

Fig. 5 depicts a flow diagram of a method for determining an illumination energy for a target polymerization according to an embodiment of the invention;

Fig. 6A-6D depict examples of computed energy deposition for a 3D object based on the low absorptivity model according to another embodiment of the invention;

Fig. 7 depicts a flow diagram of a method for determining an illumination energy for a target polymerization zone based according to an embodiment of the invention;

Fig. 8A-8D depict examples of computed energy deposition for a 3D object based on the iterative approach according to an embodiment of the invention;

Fig. 9 depicts a schematic of a system for forming a 3D object using photopolymerization according to an embodiment of the invention;

Fig. 10 is a block diagram illustrating an exemplary data computing system that may be used for executing methods and software products described in this disclosure.

Detailed description

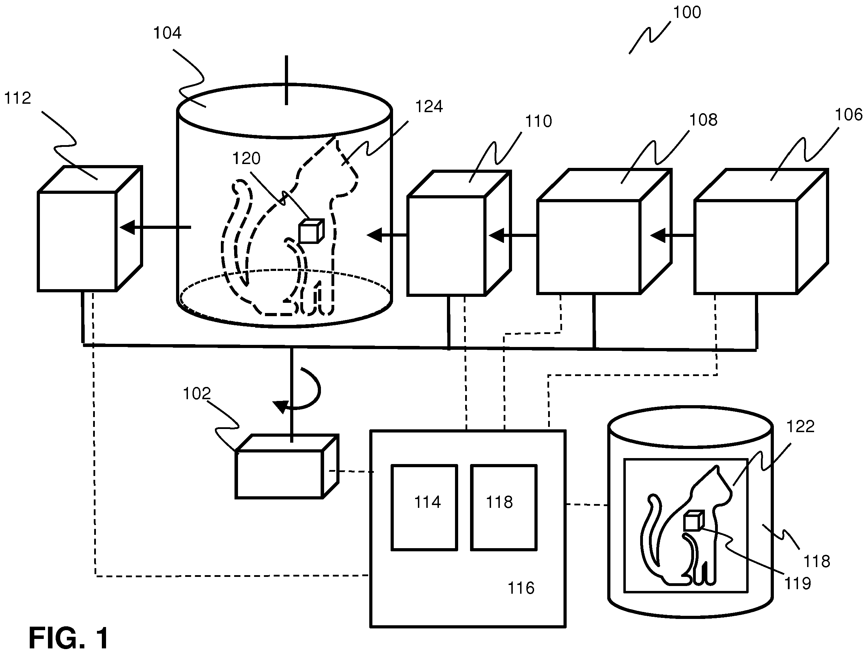

Fig. 1 depicts a schematic of an exposure system for illumination of a target zone in a photopolymerizable medium (or, in short, a medium) according to an embodiment of the invention. As shown in Fig. 1, the system 100, a 3D photopolymerization system, may comprise a container 104 enclosing a medium with a volume described by a plurality of volume elements 120 and a rotatable and/or movable illumination system, including an optical system comprising light sources 106 and optical elements 108, light modulating aperture 110 and a support structure including motors and/or actuators 102 configured to rotate and/or move the illumination system around the container at high speed (either around a single axis or multiple axes) while locally exposing the medium to light of at least one predetermined wavelength to allow illumination of the medium by light beams of predetermined intensities from different angles within a short span of time. In an embodiment, if the properties of the medium allow, the container may be rotated instead or at the same time with the rotatable illumination system.

This way, controlled exposure of locations in the medium by light of a certain intensity and wavelength may be achieved for locally triggering a photopolymerization process within a predetermined volume of the medium. This volume may be referred to as the target polymerization zone or in short the target zone. During the exposure of the target zone with an illumination beam of a predetermined intensity and wavelength incident from a single direction, a certain amount of the light energy will be absorbed by every volume element along the propagation path of that beam. Exposure of each volume element by the plurality of illumination beams incident from a large number of directions will cause deposition (by absorption of part of the light) of a certain total amount of energy. This energy may hereafter be referred to as the deposited energy field E defined for volume elements in the medium. Intensity and exposure times, corresponding to the plurality of illumination beams of each wavelength, should be configured such that the deposited energy field E is as close as possible to the target energy field $E_0$. Each incident illumination beam will propagate through the medium and the non-absorbed part will leave the medium where it may be detected by a detection system, e.g. an imaging system **112.**

A photoinduced chemical process, such as a photopolymerization process or a monomer cross-linking process, can be induced through controlled application of electromagnetic radiation (typically ultra-violet, visible light or, in some cases, infra-red) to a suitable photopolymerizable medium. Photopolymerizable media may include various types of chemical systems which may be based on e.g. free radical polymerization, cationic polymerization or acid catalysed polymerization or any other suitable polymerization process. A photopolymerizable medium may contain a photo-initiator component that, when exposed to light of a certain intensity for a certain period, may generate chemical species that participate in the reaction of polymerization. The rate of the reaction will depend, among other parameters, on the concentration of the photo-initiator, its quantum yield, and the amount of illumination energy absorbed by it. In order to improve photo-initiator sensitivity to illumination of a particular wavelength, photosensitizers can be used.

The rotatable illumination system may include at least one light source **106** for producing at least one source beam that can be pre-shaped by the optical elements **108** and modulated by a computer-controlled spatial light modular (SLM) **110.** Various readily available types of lasers or light-emitting diode sources may be used as a light source. The optical system may include optical elements positioned before and after the spatial light modulator for collimation, beam shaping and focusing. The optical elements may be selected to shape a wide, sufficiently homogeneous beam for exposing the SLM. The SLM comprises individually controllable light valves (pixels) for spatially modulating the intensity of the source beam, producing what is referred to as the illumination beam. We will assume that laws of geometrical or ray optics are applicable and that the computer-controlled light valves (the pixels) of the SLM may be used to generate a plurality of substantially parallel light rays forming a single illumination beam, while the combination of illumination beams incident from different directions is referred to as illumination field. The intensity of each illumination ray may be controlled by (at least one) of the light valves of the SLM and, depending on implementation, illumination rays that belong to one source beam can be generated simultaneously or in asynchronous manner.

An intensity modulating SLM may be used to modulate the intensity of an illumination beam depending on the direction in which the illumination beam propagates through the space in which the medium is located. The rotatable illumination system can be controlled to expose a predetermined target location of the medium by directing one or more parallel collimating intensity-modulated illumination beams from different source locations towards the target location. This way, a large number of illumination beams which intersect at the target location can be produced. The SLM may be implemented using a liquid-crystal display (LCD), digital light processing (DLP), liquid crystal on silicon (LCoS) or any other optical technology that enables modulation of illumination beams. In an embodiment, if the source used for illumination is coherent, the beam may be generated using a holographic technique instead of an intensity modulation technique. In that case, a phase modulating SLM may be used instead of an intensity modulating SLM.

In an embodiment, the optical system may comprise a detection system **112,** e.g. one or more imaging systems, which may be used to measure the intensity of the light beam that was not absorbed by the medium. The transmitted intensity of the part of the illumination beam that was not absorbed may be used to compute the current absorptivity of the medium during exposure.

The system may include one rotatable illumination system or multiple illumination systems in order to achieve faster energy deposition within the medium. Different illumination systems may comprise light sources of different wavelengths, for instance, to allow Fourier transform infrared (FTIR) measurements.

In order to generate the optimal illumination field and, hence, to deposit the target energy at predetermined locations in the target zone in the medium, the rotatable illumination system may be controlled by a computer system **116.** In particular, the computer system comprises a processor for executing one or more software programs **118** that are configured to control the system. The computer system may include a data storage connected to the processor. The data storage may comprise a 3D data representation **114** of an object of a certain shape that may be reproduced through photopolymerization. The 3D data representation may have a predetermined data format e.g. a voxel representation, point cloud representation or a 3D surface mesh representation of the 3D object **122.** Additionally, the data structure may define volume elements **119** in the 3D object in which a certain energy field needs to be deposited by one or more direction-dependent illumination beams. The processor may use the 3D data representation of the 3D object to determine a target polymerization zone **124** in the photopolymerizable medium. The target polymerization zone (or, in short, the target zone) may define a volume within the medium that is shaped according to the 3D model. In particular, the target zone may define a volume within the medium that will be exposed by the rotatable illumination system to light of an intensity and a wavelength. This way, a photopolymerization process in the target zone can be triggered (activated), maintained and, optionally, inhibited. The result of the photopolymerization process may be solid polymer copy of the object that was provided as a 3D data representation to the computer system.

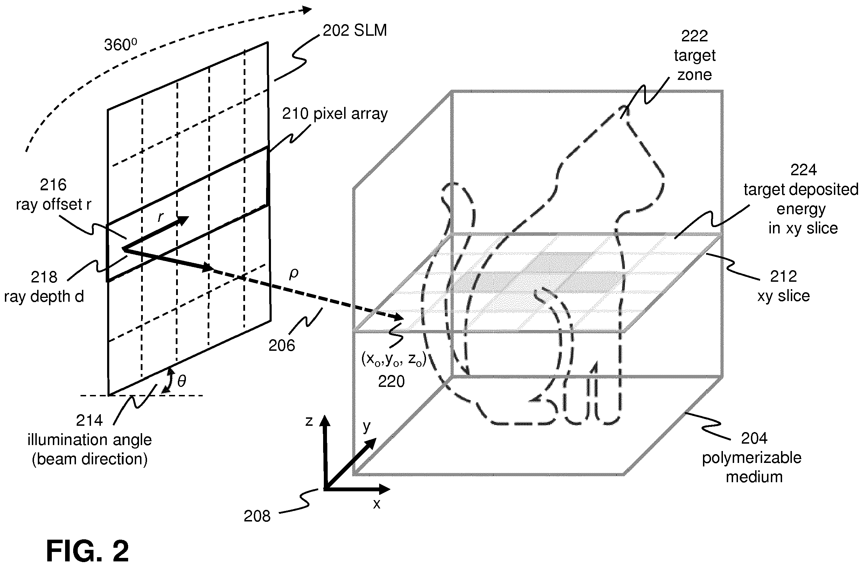

**Fig. 2** depicts a part of the system shown in **Fig. 1** in more detail. In particular, **Fig. 2** illustrates an SLM **202** that is configured to move (rotate) around a transparent container comprising a photopolymerizable medium **204.** As described with reference to **Fig. 1,** the SLM may be used to spatially modulate a source beam through the action of individually addressable light valves, thereby generating intensity modulated illumination beam. Further, various optics can be placed before and after the SLM for focusing and collimation of the illumination beam. Each computer-controlled light valve of the SLM may be used to generate an illumination ray **206** of a predetermined intensity which will contribute to the total deposited energy along its propagation path through the medium. The SLM and the container comprising the medium may be located in a space defined by a coordinate system **208**. The coordinate system may be coordinate system that is suitable for describing the target zone **222** and the propagation of illumination beams through the space, e.g. a Cartesian coordinate system based on three orthogonal axes $\{x,y,z\}$ or any other coordinate system that is suitable for defining positions in a 3D space.

To simplify the mathematical description of the processes executed by the system, it is assumed that the plane of SLM device is positioned in space parallel to the axis $z$ and can rotate around it. It is further assumed that, at least within the boundaries of the photopolymerizable medium, illumination rays propagate in a parallel fashion. In this case, the mathematical description of the transport of the illumination energy is translation invariant along axis $z$. This allows to formulate a model of energy transport and deposition based on illuminated beams modulated by any single horizontal row of SLM pixels **210** in any x-y plane **212** independently from the others and omit $z$ axis in the derivations. In practice, a set of illumination beams propagating in a parallel fashion can only be generated for rays significantly wider than the diffraction limit of the optical system. It is assumed that either the target resolution is low enough so that it is not limited by diffraction or that a parallel beam can be emulated through the use of Bessel lenses or rapid adaptive lenses such as TAG lenses or similar devices.

If the illumination beams generated by the SLM propagate in a parallel fashion, every illumination beam generated by a pixel of the SLM may be defined by:

- an illumination angle $\theta$, **214** defining an angle between the direction of the illumination beam and the x-axis,
- an offset $r$, **216** defining the position of the pixel within the horizontal row **210,**
- a height $z$, and,
- a beam length (or depth) $\rho$ **218** defining a distance between the origin of the ray and a location $\{x_0,y_0,z_0\}$ inside the medium **220.**

Controlling each row of pixels while rotating the SLM around the photopolymerizable medium allows to generate the illumination field $I_0(r,\theta,z)$ pre-computed according to the predetermined target energy $E_0(x,y,z)$ **224.**

In order to sustain a photopolymerization process in the target zone, the energy $E(x,y,z)$ absorbed by the photoinitiator at positions in the target zone needs to exceed a certain critical threshold $E_{crit}$. Alternatively, when radiation comprising a plurality (several) wavelengths is used to concurrently control initiation and, optionally, inhibition of the photopolymerization reaction, a certain linear combination of the corresponding deposited energies associated with the different wavelengths should exceed a critical value $E_{crit}$. Using the intensity-modulated illumination beams, the polymerization process can be locally controlled in a plurality of positions in the target zone, a 3D object can be formed in the medium.

The formation of a certain 3D object however may require a complex direction-dependent illumination process of the medium by the illumination system wherein parameters that contribute to the attenuation of the light during exposure may be considered. In an embodiment, a computational approach based on an analytical model describing a weakly attenuating medium may be used to determine an exposure time $t$ and illumination intensity $I_0(r,\theta,z)$ to sustain and control the polymerization reaction within an accurately defined target polymerization zone. A single or multiple exposures of the target polymerization zone may generate a solid polymer object as defined by the 3D data representation of the object that was provided to the input of the computer. Hereunder, methods and systems are described to control the system initiation and inhibition of the polymerization reaction in a target zone of a photopolymerizable medium. These embodiments are described hereunder in more detail.

The fraction of the incoming electromagnetic energy that is absorbed by a volume element of any component of the photopolymerizable medium upon illumination may be described by an absorptivity function $\mu$. Absorptivity is related to commonly used quantities, namely a molar extinction $\varepsilon$ and a concentration of the photoreactive component $C_p$, as: $\mu = \varepsilon C_p$. Instead of the standard definition of absorptivity coefficient (as commonly used in chemistry), a modified absorptivity may be used that allows to shorten mathematical notation in the mathematical description of the various embodiments in this application. The modified absorptivity may be defined as $\mu = \varepsilon C_p \cdot ln(10)$, where $ln(10) \approx 2.303$.

This function depends on the wavelength of the electromagnetic radiation and can be determined empirically or computed. When a homogeneous photopolymerizable medium is illuminated by radiation of a wavelength $\lambda$, the radiation intensity $I$ at depth $\rho$ is described by Beer-Lambert's law:

$$I(\lambda,\rho) = I(\lambda,0) \cdot \exp(-\mu_{tot}(\lambda) \cdot \rho) \qquad (1)$$

wherein $I(\lambda,0)$ is the intensity upon incidence, $\mu_{tot}(\lambda)$ is the combined absorptivity of all components of the photopolymerizable medium (photo-initiators, photosensitizers, photo-inhibitors, dyes, other attenuating additives).

By taking a derivative of the illumination intensity: $I(\lambda,\rho)$ and multiplying it by the exposure time $t$, the energy $E_{tot}(\lambda,\rho)$ absorbed by an element of volume at depth $\rho$ can be calculated:

$$E_{tot}(\lambda,\rho) = -\frac{\partial}{\partial\rho}I(\lambda,\rho)\cdot t \qquad (2)$$

$$E_{tot}(\lambda,\rho) = \mu_{tot}(\lambda)\cdot t \cdot I(\lambda,0)\cdot \exp(-\mu_{tot}(\lambda)\cdot \rho) \qquad (3)$$

Typically, only a fraction of that energy will be absorbed by the photo-initiator or/and the photosensitizer, so the amount of "useful" energy $E_+(\lambda,\rho)$ initiating the polymerization reaction may be determined by the following expression:

$$E_+(\lambda,\rho) = \mu_+(\lambda)\cdot t \cdot I(\lambda,0)\cdot \exp(-\mu_{tot}(\lambda)\cdot \rho) \qquad (4)$$

where $\mu_+(\lambda)$ is the absorptivity of the photo-initiator or the photosensitizer. The degree of polymerization that leads to formation of a solid material is typically associated with a certain critical energy $E_{crit}$, such that:

$$E_+(\lambda,\rho) > E_{crit} \qquad (5)$$

where, $E_{crit}$ can be determined empirically or calculated using reaction kinetics models.

When multiple illumination beams intersecting at a certain depth are used to initiate the reaction of polymerization, the combined intensity at the intersection point should be at least greater than the intensity at zero depth. Considering the Beer-Lambert's law, a simple condition for the minimum number of illumination beams $N_\theta$ that are needed to illuminate a single point at the centre of the volume at depth $\rho$ can be calculated:

$$N_\theta > \exp(\mu_{tot}(\lambda)\cdot \rho) \qquad (6)$$

This condition provides a rough notion of the number of illumination beams needed to create a sufficient contrast to polymerize the deepest point in the volume of a certain size before the less deep parts of the volume are polymerized. For instance, for absorptivity $\mu_{tot} = 1\ cm^{-1}$ (absorptivity considered in One-step volumetric additive manufacturing of complex polymer structures, Science Advances 8 Dec 2017, vol. 3) at least three illumination beams are needed to create enough contrast at a depth of 1 cm. However, to increase the illumination depth to 5 cm more than 300 intersecting illumination beams are required. Polymerizable media with lower absorptivity will be suitable for illumination at higher depths.

Even when condition expressed by Eq. 6 is satisfied, the illumination energy will be absorbed by the photo-initiator on its path to the target zone, thereby dramatically limiting the resolution with which the boundary of the target zone can be defined. In order to overcome the problem of limited boundary contrast, the polymerization reaction may be terminated (inhibited) in some of the previously illuminated areas. In that case, a mechanism for polymerization inhibition or polymerization deactivation can be employed. Examples of such mechanisms are known from Resolution Augmentation through Photoinduced Deactivation (RAPID) lithography, Photolnhibited Super Resolution (PInSR) lithography and multi-colour photolithography. In these approaches, a single source or multiple sources operating at different wavelengths are used to initiate the photopolymerization reaction and subsequently deactivate or substantially inhibit it.

For instance, in PInSR a photo-initiator camphorquinone sensitive to blue light is used in combination with photo-inhibitor tetraethylthiuram disulfide sensitive to ultra-violet light. In this approach, photoinitiation and photoinhibition reactions are controlled by two light sources: a blue diode-pumped solid-state laser with 473 nm wavelength and ultra-violet argon ion laser with a 365 nm wavelength. The 473 nm wavelength light is absorbed by the photo-initiator which leads to production of free radicals involved in polymerization reaction, while 365 nm light is absorbed by the photo-inhibitor and generates radical traps that terminate polymerization.

Depending on the type of the photopolymerizable medium and the type of inhibition or deactivation approach, accurate description of the kinetics of the polymerization reaction may require more complex models (typically, rate equations based on partial differential equations). In an embodiment, a semi-empirical model for describing the activation and inhibition of the polymerization process may be used. In such scheme, polymerization may be achieved when a certain linear combination of the energy associated with initiation $E_+$ and the energy associated with inhibition (or deactivation) of the polymerization $E_-$ exceeds a critical value:

$$E_+(\lambda_+, \rho) - \beta \cdot E_-(\lambda_-, \rho) > E_{crit}, \qquad (7)$$

wherein the parameter $\beta$ is a proportionality constant and the wavelengths $\lambda_+$ and $\lambda_-$ are respectively wavelengths at which the photo-initiator and the photo-inhibitor absorb photons respectively. Constant $\beta$ may be computed using rate equations or measured for a particular photopolymerizable medium. A resulting combined deposited energy $E(\lambda, \rho)$ may define a linear combination of deposited energies $E_+(\lambda_+, \rho) - \beta \cdot E_-(\lambda_-, \rho)$ for systems with "active" inhibition. In case of "passive" inhibition the deposited energy can be described by the single term $E_+(\lambda_+, \rho)$ minus a constant. An expression for the deposited energy with a larger number of terms can be considered for systems with a larger number of photosensitive components.

In an embodiment, a computational approach may be used to compute the illumination intensity for each direction of illumination that is required to facilitate deposition of the correct quantities of initiation energy $E_+$ and inhibition energy $E_-$ in every location of the polymerization volume. The underlying mathematical model of the deposited energy $E(x,y,z)$ may be defined as follows:

$$E(x, y, z) = t \cdot \mathcal{M} I_0(r, \theta, z), \qquad (8)$$

wherein $M$ is an operator that describes the deposition of energy in the volume of photopolymerizable medium given a direction-dependent illumination field $I_0(r, \theta, z)$. An optimal illumination field $I_0(r, \theta, z)$ may be computed by searching for a solution for Eq. 8 after substituting the target energy field $E_0(x,y,z)$ in the right-hand side of the equation. If an inverse operator $\mathcal{M}^{-1}$ can be calculated, an analytical solution may be used:

$$I_0(r, \theta, z) = \frac{1}{t} \cdot \mathcal{M}^{-1} E_0(x, y, z) \qquad (9)$$

Otherwise, an iterative solver algorithm may be used to find an approximated solution to Eq. 8. For instance, a well-known Least-Squares minimization algorithm may be employed to find $I_0(r, \theta, z)$ corresponding to a minimum of an objective function:

$$\underset{I_0}{argmin} \, |t \cdot \mathcal{M} I_0(r, \theta, z) - E_0(x, y, z)|_2^2 \qquad (10)$$

Wherein the notation $|\cdot|_2^2$ denotes the Euclidean norm (or L2 norm). A regularization term of some sort can be added to the L2 term to constrain possible solutions for $I_0(r, \theta, z)$ to physically more appropriate ones.

Operator $\mathcal{M}$ may be based on a model of photon propagation and absorption inside the photopolymerizable medium and its particular form may depend on one or more parameters, including e.g. parameters of the illumination system, type of the medium and the level of acceptable approximations. This operator may hereafter be referred to as the propagation operator $\mathcal{M}$. Below a more detailed embodiment of an implementation of the propagation operator $\mathcal{M}$ based on the Radon transform is provided. In this embodiment, it is assumed that photons propagate along straight paths in a parallel fashion. More accurate models such as a model based on the so-called Radiative Transport Equations may be used when effects such as refraction, diffraction and/or scattering are considered.

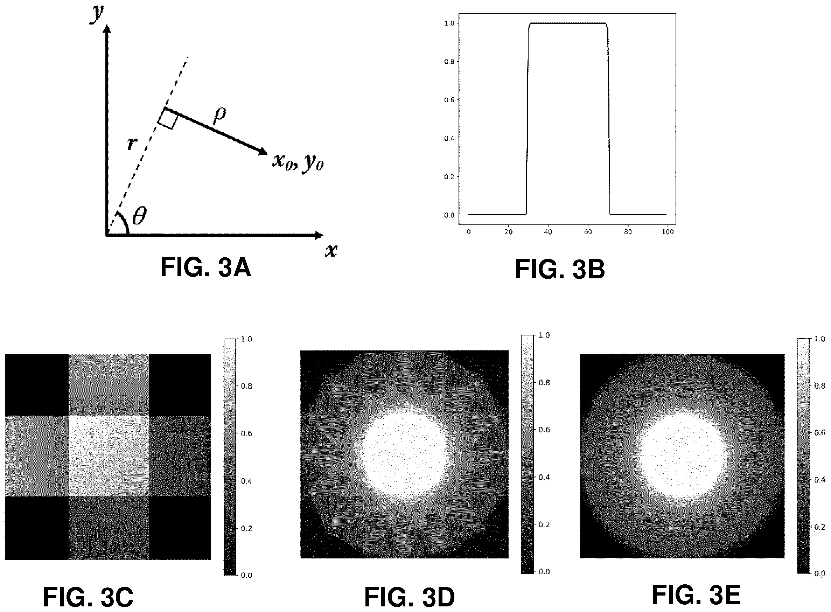

**Fig. 3A-3E** depict a simulated energy deposition resulting from a superposition of multiple illumination beams, wherein beams of uniform intensity are used. In this example, the target shape is a solid cylinder in a photopolymerizable medium with absorptivity of 1 cm$^{-1}$ inside a container of dimensions $1 \times 1$ cm (in x-y plane). **Fig. 3A** depicts the relation between the {x,y} coordinates and the {r,p,$\theta$} coordinates (as described in detail with reference to **Fig. 2. Fig. 3B** depicts a normalized intensity profile of a 0.4 cm wide illumination beam of uniform intensity. **Fig. 3C** depicts a simulated energy field deposited in a photopolymerizable medium when two orthogonal illumination beams of uniform intensity are used. By extending the illumination process to a higher beam number, it is possible to generate a the deposited energy field that is closer to a circular target energy field. **Fig. 3D and 3E** depict examples of the deposited energy field resulting from 16 and 314 illumination beams respectively. In **Fig. 3E** a circular distribution of the energy is achieved wherein each point of the medium that absorbs energy larger than a critical energy $E_{crit}$ will be polymerized. However, as shown in these figures, the polymerization zone does not exhibit a sharp boundary in this example since energy of every incoming illumination beam is absorbed along the whole propagation path. This will lead to a substantial loss of resolution due to fluctuations in the properties of the photopolymerizable medium and errors in the illumination.

As described with reference to **Fig. 3A,** any position (defined by the coordinates {x,y}) on a 2D plane can be illuminated by a plurality of illumination rays characterized by illumination angle $\theta$, offset $r$ and depth $\rho$. This two-dimensional description is sufficient for the case of parallel beam illumination with rotation around axis z (due to translational invariance along the rotation axis). In more complex cases, the scheme may be easily generalized to three-dimensions based on a suitable coordinate system.

The intensity of the illumination may be described by a direction depended illumination field $I_0(r,\theta)$. A location {x,y} can be illuminated only by sources located on straight lines intersecting with that location, so that the offset $r_0$ of these illumination sources may be described by the following expression:

$$r_0(\theta) = x \cdot \cos(\theta) + y \cdot \sin(\theta) \tag{11}$$

and the total intensity that is directed to a location {x,y} can be described by an integral:

$$I(x,y) = \int_0^{2\pi} \int_{-\infty}^{\infty} I_0(r,\theta) \cdot \delta(x \cdot \cos(\theta) + y \cdot \sin(\theta) - r) dr d\theta \tag{12}$$

Here $\delta(\cdot)$ represents a Dirac function. To account for attenuation of light along its propagation path, an integral absorptivity factor is introduced in accordance with Beer-Lambert's law. To do that, an absorptivity has to be defined on the x-y grid parametrized by the depth $\rho$ and offset $r_0(\theta)$:

$$x = r_0(\theta) \cdot \cos(\theta) + \rho \cdot \sin(\theta)$$

$$y = r_0(\theta) \cdot \sin(\theta) - \rho \cdot \cos(\theta) \tag{13}$$

Combining Eq. 11 and Eq. 13, one finds an expression for Beer-Lambert's law of attenuation based on the total absorptivity of the polymerization medium $\mu_{tot}(x,y)$ for the direction $\theta$. This attenuation term $T(x,y,\theta)$ looks as follows:

$$T(x,y,\theta) = \exp(-\int_{-\infty}^{\rho_0} \mu_{tot} (\rho \cdot \sin(\theta) + (x \cdot \cos(\theta) + y \cdot \sin(\theta)) \cdot \cos(\theta),$$

$$-\rho \cdot \cos(\theta) + (x \cdot \cos(\theta) + y \cdot \sin(\theta)) \cdot \sin(\theta)) d\rho \tag{14}$$

where depth $\rho = -\infty$ corresponds to the outwards direction and depth $\rho = \rho_0$ corresponds to the location {x,y} inside the medium. Value of $\rho_0$ can be expressed through $x,y$ and $\theta$ as:

$$\rho_0 = x \cdot \cos(\theta) - y \cdot \sin(\theta) \tag{15}$$

The attenuated total illumination intensity $\hat{I}$ at location {x,y} can be derived by combining the expression for the total illumination intensity from Eq. 12 with the attenuation term from Eq. 14:

$$\hat{I}(x,y) = \int_0^{2\pi} \int_{-\infty}^{\infty} I_0(r,\theta) \cdot \delta(x \cdot \cos(\theta) + y \cdot \sin(\theta) - r) dr \cdot T(x,y,\theta) d\theta$$

$$\tag{16}$$

Finally, assuming that the absorptivity is constant within the boundaries of the photopolymerizable medium, the energy $E(x,y)$ associated with photo-initiation at any point {x,y} can be computed similarly to Eq. 4:

$$E(x,y) = \mu_+ \cdot t \cdot \int_0^{2\pi} \int_{-\infty}^{\infty} I_0(r,\theta) \cdot \delta(x \cdot \cos(\theta) + y \cdot \sin(\theta) - r)dr \cdot T(x,y,\theta)d\theta$$

$$(17)$$

Now, the direction-dependent illumination intensity $I_0(r,\theta)$ can be computed by solving Eq. 17 after substitution of the target energy $E_0(x,y)$ into the right-hand side. In a system with active photo-initiation and photo-inhibition, two terms should be considered, such that $E(x,y) = E_+(x,y) - \beta \cdot E_-(x,y)$ and:

$E(x,y) > E_{crit}$, for {x, y} inside the target polymerization zone,

$$E(x,y) < E_{crit}, \text{ for \{x, y\} outside of the target polymerization zone} \quad (18)$$

To find an analytical solution for Eq. 18 a weakly attenuating medium may be assumed, neglecting the attenuation term $T(x,y,\theta)$ in the Eq. 17. In that case, the expression for the deposited illumination energy $E(x,y)$ may be simplified:

$$E(x,y) = \mu_+ \cdot t \cdot \int_0^{2\pi} \int_{-\infty}^{\infty} I_0(r,\theta) \cdot \delta(x \cdot \cos(\theta) + y \cdot \sin(\theta) - r)dr d\theta \quad (19)$$

In fact, the integral in Eq. 19 is a form of the so-called adjoint Radon transform and allows to compute an optimal illumination intensity analytically. A definition for the Radon transform and its adjoint form is provided hereunder. The Radon transform is a linear transformation that defines a series of line integrals applied to a function $f(x,y)$ defined on a 2D plane. It can be written in the following form:

$$p(r,\theta) = \int_{-\infty}^{\infty} \int_{-\infty}^{\infty} f(x,y) \cdot \delta(x \cdot \cos(\theta) + y \cdot \sin(\theta) - r)dx dy \quad (20)$$

this transformation may be referred to as the forward Radon transform. Here, the direction-dependent function $p(r, \theta)$ may be regarded as a collection of projections of an image defined by $f(x,y)$, which is often used in Computer Tomography applications. The adjoint Radon transform can be defined by the following integral:

$$f(x,y) = \int_{-\infty}^{\infty} \int_0^{2\pi} \hat{p}(r,\theta) \cdot \delta(x \cdot \cos(\theta) + y \cdot \sin(\theta) - r)d\theta dr \quad (21)$$

wherein the function $\hat{p}(r,\theta)$, to which the adjoint Radon transform is applied, can be related to the result of the forward Radon transform $p(r,\theta)$ (Eq. 20) through convolution or Fourier filtering (a so-called ramp filter or similar):

$$\hat{p}(r,\theta) = \int_{-\infty}^{\infty} |\omega| \left( \int_{-\infty}^{\infty} p(\bar{r},\theta) \cdot \exp(-j2\pi\bar{r}\omega)d\bar{r} \right) \cdot \exp(j2\pi r\omega)d\omega \quad (22)$$

Integrals in Eq. 20-22 can be written in the form of linear operators leading to the following expressions:

$$p(r,\theta) = \mathcal{R}f(x,y),$$

$$f(x,y) = \mathcal{R}^*\hat{p}(r,\theta), \quad (23)$$

$$\hat{p}(r,\theta) = \mathcal{F}p(r,\theta),$$

wherein $\mathcal{R}$ and $\mathcal{R}^*$ are the Radon transform and its adjoint version respectively, and $\mathcal{F}$ is the Fourier filtering operator. Using this notation, a function $f(x,y)$ can be expressed through the adjoint Radon transform of its own filtered projection:

$$f(x,y) = \mathcal{R}^*\mathcal{F}\mathcal{R}f(x,y) \qquad (24)$$

Hence, according to Eq.19, in an embodiment, the deposited energy can be modelled as an adjoint Radon transform of the direction-dependent illumination intensity $I_0(r,\theta)$:

$$E(x,y) = \mu_+ \cdot t \cdot \mathcal{R}^* I_0(r,\theta) \qquad (25)$$

Comparing Eq. 25 with Eq. 24, it can be seen that the illumination intensity $I_0(r,\theta)$ that corresponds to a certain deposited energy $E(x,y)$, can be computed using a filtered Radon transform:

$$I_0(r,\theta) = \frac{1}{\mu_+\cdot t}\mathcal{F}\mathcal{R}[E(x,y)] \qquad (26)$$

Hence, this equation is a special case of Eq. 9 and may be used to calculate the direction-dependent intensity of illumination analytically in case of a weakly attenuating polymerization medium.

The optimal direction-dependent illumination intensity $I_0(r,\theta)$ according to Eq. 26 may be solved for a finite number of illumination angles and associated illumination beams, thus integrals in linear operators are replaced by finite sums. To avoid sampling artefacts, the number of offsets (i.e. illumination rays) $N_r$ in each illumination beam may correspond to the desired spatial resolution of $E(x,y)$. Further, to avoid aliasing artefacts, the number of illumination angles (i.e. illumination beams) $N_\theta$ may be related to the number of offsets $N_r$ by using the expression: $N_\theta \geq \pi N_r$. For instance, when an image of $1024 \times 1024$ pixels needs to be formed by multi-directional illumination of a target zone, approximately 3200 illumination beams with 1024 rays each may be generated in 0 to $2\pi$ angular range.

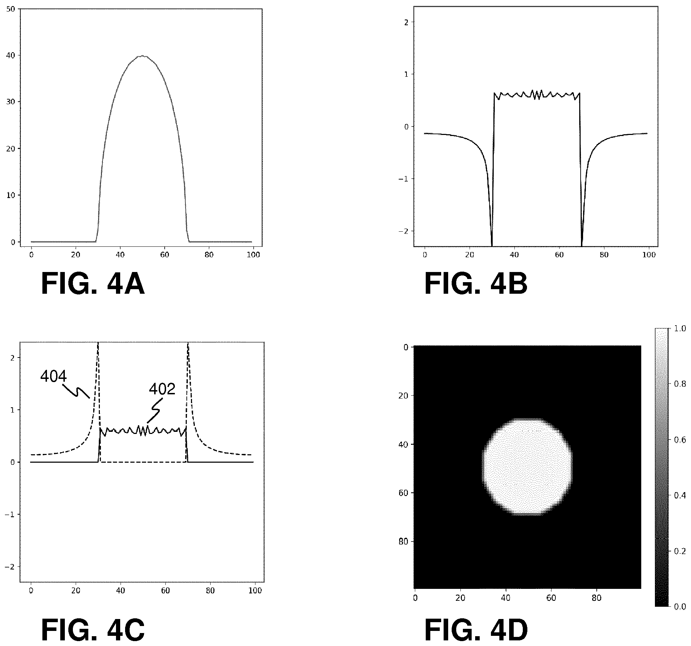

**Fig. 4A-4D** depict a simulated energy deposition resulting from a superposition of multiple illumination beams, wherein beams were precomputed and generated according to an analytical model valid for media with weak absorptivity. The multiple illumination beams were pre-computed using an analytical model described above. **Fig. 4A** depicts a Radon transform (projected image) of a target energy $\mathcal{R}[E(x,y)]$. It is the same in every direction, as the target polymerization zone is circular in this example. **Fig. 4B** depicts an illumination field $I_0(r,\theta)$ computed by applying a Fourier filter (e.g. ramp filter) to the Radon transform of the target energy field as defined by Eq. 26. It is apparent that the computed illumination intensity has negative values which do not have any physical meaning in a read-world system. The negative values however can be associated with the intensity of the light interacting with the inhibition/deactivation agent. In an embodiment, in case of passive (ambient) inhibition, a constant offset can be added to the illumination intensity that matches the effect of the inhibitor. This way the illumination intensity will always be above zero. Alternatively, in another embodiment, in case of active inhibition, $I_0(r,\theta)$ can be separated into two terms related to the initiation and inhibition: $I_0(r,\theta) = I_+(r,\theta) - \beta.\, I_-(r,\theta)$. In that case, the terms can be defined as:

$$I_+(r,\theta) = \begin{cases} |I_0(r,\theta)|, & if\ I_0(r,\theta) > 0 \\ 0, & otherwise \end{cases}$$

$$I_-(r,\theta) = \begin{cases} -|I_0(r,\theta)|/\beta, & if\ I_0(r,\theta) < 0 \\ 0, & otherwise \end{cases} \qquad (27)$$

**Fig. 4C** depicts the intensity of the photo-initiation illumination field $I_+(r,\theta)$ (**402** continuous line) and the intensity of the photo-inhibition illumination field $I_-(r,\theta)$ (**404** dotted line). The associated (combined) deposited energy field $E(x,y)$ resulting from illumination by 314 beams is depicted in **Fig. 4D.** The wavelength of the initiation illumination differs from the wavelength of the inhibition illumination. As the linear absorptivity may be wavelength dependent, absorptivity associated with the initiation illumination may be different from the absorptivity associated with the inhibition illumination. In contrast to the example with the uniform intensity beam illumination (**Fig. 3E**), an approach described above leads to a sharply defined polymerization zone allowing for high resolution of the printed object boundary.

The computation described above is based on the assumption of weak absorption, where the direction-dependent absorption term is neglected. Reviewing Eq. 17, where the energy is expressed including the absorption term $T(x,y,\theta)$, a Radon-based computation method can be derived that incorporates self-absorption by the medium. To simplify the description, it may be assumed that the total absorptivity at the wavelength that corresponds to $I_+(r,\theta)$ term and to

$I_-(r,\theta)$ is the same: $\mu_+ = \mu_- = \mu$. To this end, Eq. 17 can be rewritten for the photo-initiation and photo-inhibition energy terms using a short operator notation:

$$E_+(x,y) = \mu \cdot t \cdot \widetilde{\mathcal{R}}^* I_+(r,\theta)$$
$$E_-(x,y) = \mu \cdot t \cdot \widetilde{\mathcal{R}}^* I_-(r,\theta) \qquad (28)$$

where $\widetilde{\mathcal{R}}^*$ is a modified adjoint Radon transform incorporating an attenuation term $T(x,y,\theta)$. Now, Eq. 28 can be condensed into the following form:

$$E(x,y) = \mu \cdot t \cdot \widetilde{\mathcal{R}}^* I_0(r,\theta) \qquad (29)$$

Combining this result with the polymerization condition expressed in Eq. 18, the optimal illumination intensity functions $I_+(r,\theta)$ and $I_-(r,\theta)$ can be computed for a given target energy $E_0(x,y)$ using a Least-Squares approach described by Eq. 10 where the propagation operator $\mathcal{M}$ equals to $\mu \cdot \widetilde{\mathcal{R}}^*$:

$$\underset{I_0(r,\theta)}{argmin} \left| \mu \cdot t \cdot \widetilde{\mathcal{R}}^* I_0(r,\theta) - E_0(x,y) \right|_2^2 \qquad (30)$$

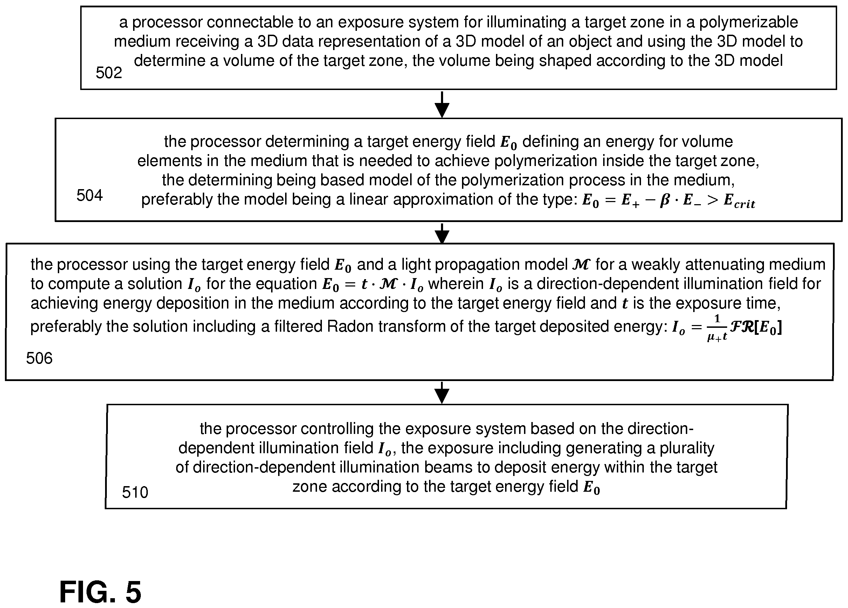

**Fig. 5** depicts a flow diagram describing a method of controlling an illumination system for illuminating a target zone in a photopolymerizable medium according to an embodiment of the invention. The method may include determining direction-dependent illumination field based on target energy field determined for a target polymerization zone based and a low absorptivity light propagation model. The method may be implemented on a computer in the form of program code stored in the memory of the computer. The program code may be executed by a processor of the computer thereby enabling the computer to determine direction-dependent illumination intensities which can be used to control an exposure system, e.g. a system as described with reference to **Fig. 1.** The computed illumination intensity may be used to control and generate a plurality of direction-dependent exposures leading to the desired photopolymerization of the target zone.

In a first step, a 3D data representation representing a 3D model of an object may be provided to a computer that is connected to an exposure system for illumination of the target zone, e.g. an exposure system described with reference to **Fig. 1** and **2.** The computer may use the 3D model to determine a volume of a target polymerization zone in the photopolymerizable medium **502,** wherein the volume is shaped according to the 3D model. In a next step **504,** the computer may use the target polymerization zone to determine a target energy field $E_0$. The target energy field may define the energy that is need to achieve polymerization inside the target polymerization zone or in short the target zone. The determination of the target energy field may be based on a model of the photopolymerization process. Here a model of the photopolymerization process may include e.g. a (linear) empirical model of the photopolymerization process or a model of the photopolymerization process based on the polymerization kinetics. In an embodiment, a linear (empirical) model of the type $E_0 = E_+ - \beta \cdot E_-$ may be used to determine the target energy wherein polymerization is achieved when a weighted difference between the energy absorbed by the photo-initiator $E_+$ and the energy absorbed by the inhibitor (or involved in deactivation of polymerization on another way) $E_-$ exceeds a certain critical value $E_{crit}$.

The computer may then use the target energy field $E_0(x,y,z)$ and a light propagation model for a weakly attenuating medium to compute a direction-dependent illumination field $I_0(r,\theta,z)$ (step **506**). In a weakly attenuating medium a projection of the target energy field $E_0(x,y,z)$ can be computed for every direction of illumination. A projection $p(r,\theta,z)$ of the target energy $E_0(x,y,z)$ can be computed by applying a forward projection operator based on the Radon transform $\mathcal{R}$ (or similar transforms computing projections of a 3D image) to the target energy field. Subsequently a linear convolutional filter $\mathcal{F}$ (e.g. ramp or Ram-Lak filter) may be applied to the projection of the energy thereby defining a direction-dependent illumination field $I_0(r,\theta,z)$. Hence, the illumination field may be determined on the basis of a filtered Radon transform of the target energy field as defined by eq. (26) above. In a next step **510,** the computed illumination field $I_0(r,\theta,z)$ may be used by the computer to control the exposure system based on the illumination field, wherein the exposure may include generating a plurality of direction-dependent illumination beams for depositing energy at positions within the target zone according to the target energy $E_0(x,y,z)$. Here, it is assumed that the power of the illumination source and the exposure time are kept constant, while the intensity $I_0(r,\theta,z)$ is controllably varied, e.g. by controlling the pixels of the SLM and the illumination angle. The illumination angles and associated illumination intensities may be used to control the rotation of the rotatable illumination system and to control the SLM in the rotatable illumination system depicted in **Fig. 1.** It is submitted that the target energy field and the intensity field as mentioned above may be described based on coordinate systems that are suitable for a particular case. Selection of such coordinate systems, as well as the type of the Fourier filter and the projection transformation may depend on the symmetry of the setup (e.g. cylindrical or spherical symmetry)

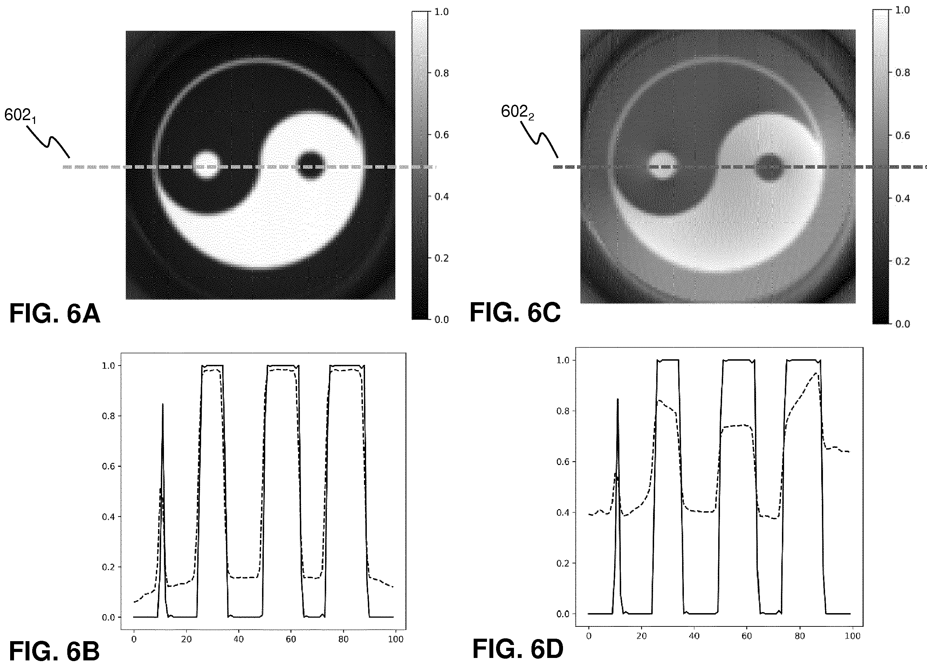

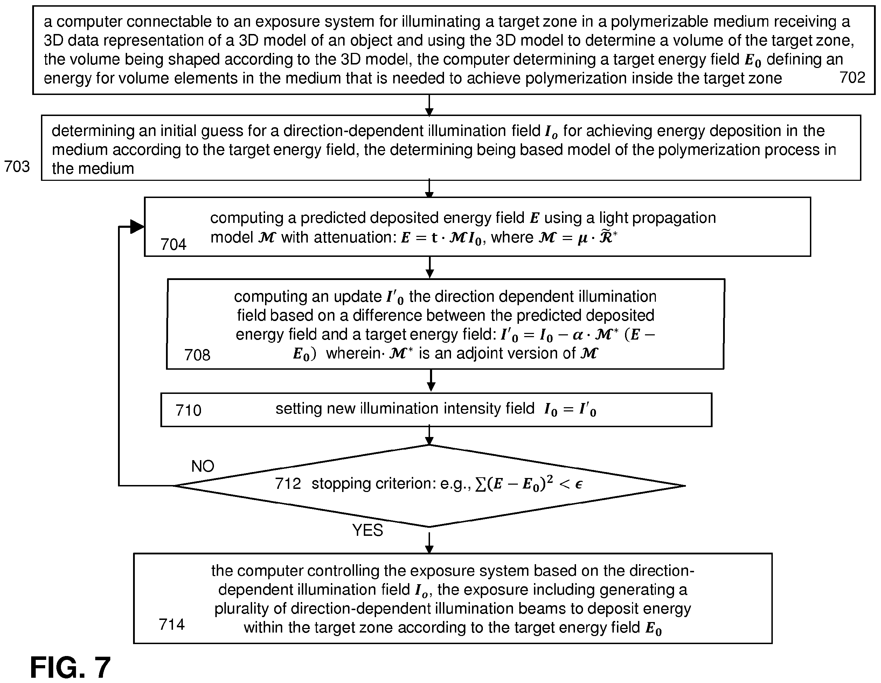

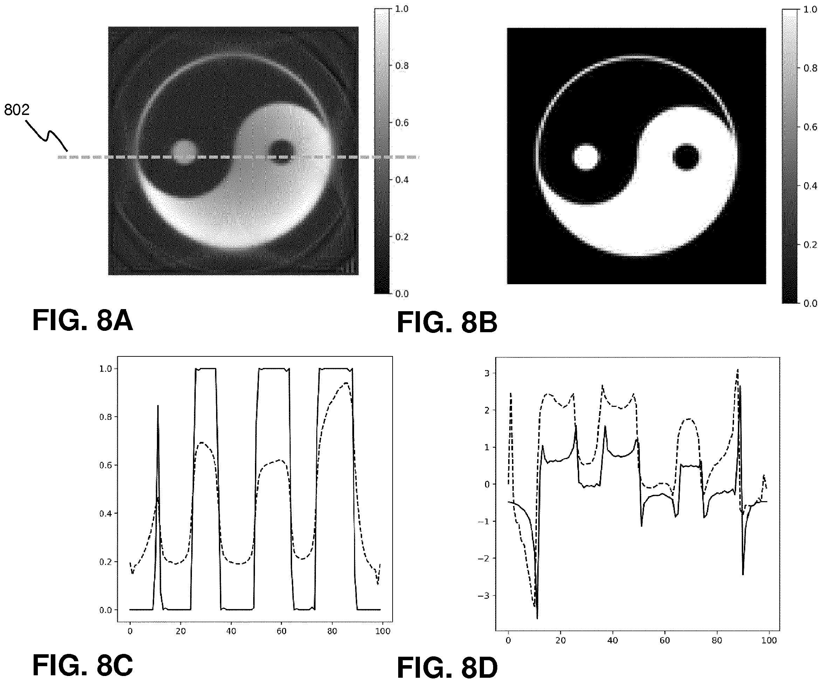

**Fig. 6A-6D** depict examples of computed energy deposition for a 3D object (x-y slice displayed) based on the weak absorptivity model according to an embodiment of the invention. In particular, **Fig. 6A-6D** depict examples of computed energy deposition for a fairly complex object, in this case a $1 \times 1$ cm image of an Yin-Yang shaped object. **Fig. 6A-B** and **Fig. 6C-D** depict computed energy deposition for the 3D object in a moderate absorptivity medium ($\mu = 1$ cm$^{-1}$) and a high absorptivity medium ($\mu = 5$ cm$^{-1}$) medium respectively. **Fig. 6B** and **6D** represent cross-sections through the mid-line **602$_{1,2}$** of **Fig. 6A** and **6C** respectively, wherein the solid line represents the profile of the target energy and wherein the dashed line represents the actual deposited energy. The images depicted in these figures are formed by 314 beams of 100 rays each. **Fig. 6A** and **6B** show that in a moderately attenuating medium, an accurate image of the object can be formed by multi-directional illumination with intensity calculated using weak absorptivity model. **Fig. 6C** and **6D** show that when the absorbance of the medium is high (or the size of the volume is too large), such approach may provide poor contrast. In that case, an iterative approach may be used to determine the illumination intensity. This approach is described hereunder in more detail with reference to **Fig. 7** and **Fig. 8.**

The photopolymerizable medium and the illumination wavelength may be selected to minimize these effects. Eventually, a more precise model relating the illumination field to the deposited energy field (for the photo-initiator and the inhibitor) can be used for a particular implementation of the illumination system.

A further assumption that was made in order to derive Eq. 29 is that the absorptivity is constant in time and does not change as a result of illumination. Concentrations of the photo-initiator and the inhibitor however may locally change during the illumination of the medium by the illumination beams leading to the change in absorptivity. Similarly, as a result of polymerization dynamics, the proportionality constant $\beta$ in the polymerization condition as expressed by Eq. 7 may vary during the illumination.

To account for unknown changes in the parameters of the photopolymerizable medium, the computation of energy deposition and the associated illumination may be separated into a number of iterations, where during each iteration the medium is exposed to a relatively low illumination energy wherein parameters of the medium can be considered constant. One way to monitor parameters of the medium is to measure the intensity of light transmitted through the medium during the illumination process. If such measurement is available, the linear absorptivity of the medium can be computed using known Computer Tomography methods as for example described by Herman, G. T., Fundamentals of computerized tomography: Image re-construction from projection, 2nd edition, Springer, 2009, using e.g. a filtered back projection method:

$$\mu(x,y) = \mathcal{R}^* \mathcal{F}\left[-\log\left(\frac{I_{out}(r,\theta)}{I_0(r,\theta)}\right)\right] \qquad (31)$$

wherein, $I_{out}(r,\theta)$ is the intensity of the light transmitted through the medium. A real-time measurement of the degree of polymerization can be obtained using more elaborate spectral measurements of transmitted light using Fourier-transform infrared spectroscopy (FTIR) tomography methods as described in 3D spectral imaging with synchrotron Fourier transform infrared spectro-microtomography Nature Methods volume 10, pages 861864 (2013).

**Fig. 7** depicts a flow diagram of a method for determining an illumination field $I_0(r,\theta,z)$ for a target polymerization zone according to another embodiment. In particular, **Fig. 7** depicts a flow diagram of a method for determining an illumination energy based on an iterative approach for media with a moderate absorptivity according to an embodiment of the invention. In such iterative approach, an approximated solution for an illumination intensity may be computed for each direction through an iterative minimization of an objective function that describes the discrepancy between a target energy field $E_0(x,y,z)$ and a predicted deposited energy field $E(x,y,z) = t \cdot \mathcal{M} I_0(r,\theta,z).$ A propagation operator $M$ may be used for predicting the energy deposition. For example, a propagation operator based on the adjoint Radon transform as described with reference to **Fig. 5** may be used. Such adjoint Radon transform uses a propagation model with an absorptivity term and assumes that photons propagate along straight lines in a parallel fashion. It may be replaced by more accurate models (for instance Radiative Transport Equations) in situations when such assumption fails. A wide range of algorithms may be used to solve the Least Squares-type minimization problem. In **Fig. 7** a basic approach is described that is applicable to cases with linear propagation model $\mathcal{M}$ .

The iterative minimization method may be used once a target energy field is determined (as in step **504** of **Fig. 5)** and the output of the method may be used to control and generate direction-dependent illumination field defining a plurality of exposures of a target zone which leads to photopolymerization of the target zone (as described in set **510** of **Fig.** 5). This analytically determined illumination intensity function may be a first estimate of the illumination field that is used in the iterative minimization method (step **702**).

In a next step **704** the deposited energy field $E(x,y,z)$ is predicted. In an embodiment, the predicted energy may be computed using a modified adjoint Radon transform with an absorptivity term represented by a linear operator $\mathcal{M}$ . This modified adjoint Radon transform $\mathcal{R}^*$ is described with reference to eq. (28)-(30) above.

In the following step, **708** a gradient should be computed for an objective function based on the difference between the predicted and the target energy. If the objective function is of an L2-type (Euclidian distance) the gradient as computed by applying $\mathcal{M}^*$ i.e. an adjoint version of the linear operator $\mathcal{M}$ , to the difference $E(x,y,z)$ - $E_0(x,y,z)$. An update of the current guess of the illumination field $I_0(r,\theta,z)$ is computed by subtracting the calculated gradient of the objective function scaled by a constant factor $\alpha$. The result of this operation is the new guess of the illumination intensity function $I_0(r,\theta,z)$ **710.**

Different stopping conditions **712** can be implemented. For instance, to stop when the sum of squares of the discrepancy $E(x,y,z)$ - $E_0(x,y,z)$ is lower than some small constant $\varepsilon$. If the condition is not satisfied a new iteration of the method is started by substitution of the updated illumination intensity function $I_0(r,\theta,z)$ **710** into step **704.** If it is satisfied, the current guess of the illumination intensity may be used to control the illumination system **714.** Also in this case, the target energy field and the intensity field may be described based on coordinate systems that are suitable for a particular case.

**Fig. 8A-8D** depict examples of computed energy deposition for a 3D object based on the iterative approach for media with moderate absorptivity according to an embodiment of the invention. **Fig. 8A** depicts a computed deposited energy field in a high absorptivity medium ($\mu$ = 5cm$^{-1}$) for a Yin Yang shaped object. **Fig. 8B** depicts the target energy field. **Fig. 8C** represents a cross-section through the mid-line **802** of **Fig. 8A,** wherein the solid line represents the profile of the target energy and wherein the dashed line represents the actual deposited energy. The images depicted in these figures are formed by 314 beams of 100 rays each. **Fig. 8D** shows the illumination field intensity profile for one of the directions of illumination, wherein the solid line represents the intensity profile precomputed using the analytical solution for the weak absorptivity model and the dashed line represents the intensity profile precomputed using an iterative approach applied to the model with significant absorptivity. When the absorptivity of the medium is high (or the size of the volume is too large), the approach based on the model for a weak absorptivity medium delivers poorer contrast and eventually fails. In that case, an iterative approach may be used to determine the illumination intensity. This approach is described above with a reference to **Fig. 7.**

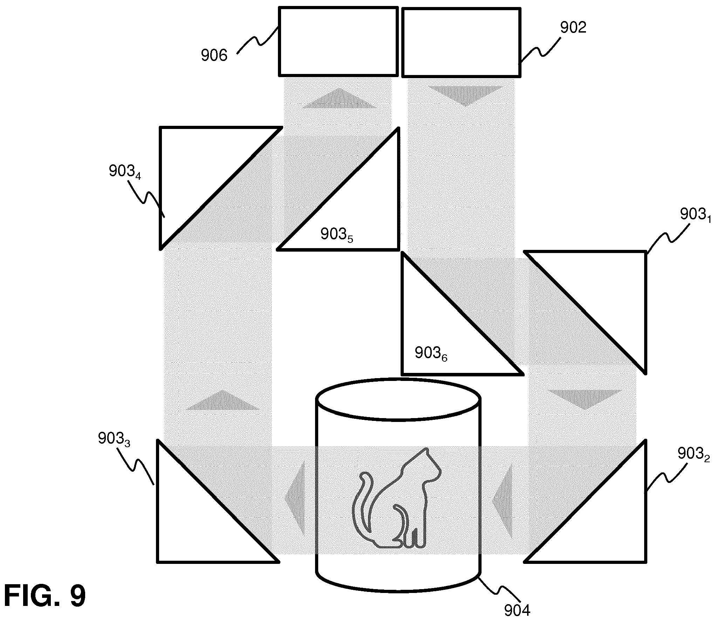

**Fig. 9** depicts a schematic of a system for forming a 3D object using photopolymerization according to an embodiment of the invention. **Fig. 9** shows a schematic of the illumination arm implementation where the sources **902** and cameras **906** remain stationary, while moving mirrors **903$_1$**-**903$_6$** ensure positioning of the illumination beam. Different variations of this concept can be realized using mirrors or other light guiding systems. If the viscosity of the medium allows, the container itself **904** can be rotated, while the illumination system remains stationary.

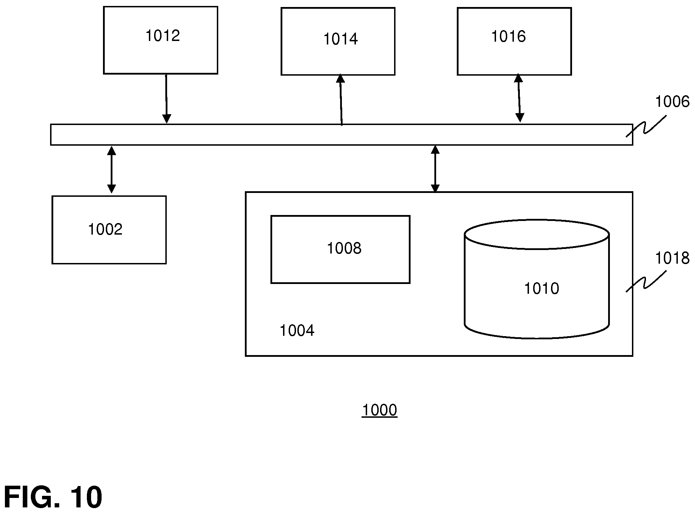

**Fig. 10** is a block diagram illustrating an exemplary data processing system that may be used in as described in this disclosure. Data processing system **1000** may include at least one processor **1002** coupled to memory elements **1004** through a system bus **1006**. As such, the data processing system may store program code within memory elements **1004.** Further, processor **1002** may execute the program code accessed from memory elements **1004** via system bus **1006.** In one aspect, data processing system may be implemented as a computer that is suitable for storing and/or executing program code. It should be appreciated, however, that data processing system **1000** may be implemented in the form of any system including a processor and memory that is capable of performing the functions described within this specification.

Memory elements **1004** may include one or more physical memory devices such as, for example, local memory **1008** and one or more bulk storage devices **1010.** Local memory may refer to random access memory or other non-persistent memory device(s) generally used during actual execution of the program code. A bulk storage device may be implemented as a hard drive or other persistent data storage device. The processing system **1000** may also include one or more cache memories (not shown) that provide temporary storage of at least some program code in order to reduce the number of times program code must be retrieved from bulk storage device **1010** during execution.

Input/output (I/O) devices depicted as input device **1012** and output device **1014** optionally can be coupled to the data processing system. Examples of input device may include, but are not limited to, for example, a keyboard, a pointing device such as a mouse, or the like. Examples of output device may include, but are not limited to, for example, a monitor or display, speakers, or the like. Input device and/or output device may be coupled to data processing system either directly or through intervening I/O controllers. A network adapter **1016** may also be coupled to data processing system to enable it to become coupled to other systems, computer systems, remote network devices, and/or remote storage devices through intervening private or public networks. The network adapter may comprise a data receiver for receiving data that is transmitted by said systems, devices and/or networks to said data and a data transmitter for transmitting data to said systems, devices and/or networks. Modems, cable modems, and Ethernet cards are examples of different types of network adapter that may be used with data processing system **1050.**

As pictured in **FIG. 10,** memory elements **1004** may store an application **1018.** It should be appreciated that data processing system **1000** may further execute an operating system (not shown) that can facilitate execution of the application. Application, being implemented in the form of executable program code, can be executed by data processing system **1000,** e.g., by processor **1002.** Responsive to executing application, data processing system may be configured to perform one or more operations to be described herein in further detail.

In one aspect, for example, data processing system **1000** may represent a client data processing system. In that case, application **1618** may represent a client application that, when executed, configures data processing system **1000** to perform the various functions described herein with reference to a "client". Examples of a client can include, but are not limited to, a personal computer, a portable computer, a mobile phone, or the like. In another aspect, data processing system may represent a server. For example, data processing system may represent an (HTTP) server in which case application **1018,** when executed, may configure data processing system to perform (HTTP) server operations. In another aspect, data processing system may represent a module, unit or function as referred to in this specification.

The terminology used herein is for the purpose of describing particular embodiments only and is not intended to be limiting of the invention. As used herein, the singular forms "a," "an," and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

The corresponding structures, materials, acts, and equivalents of all means or step plus function elements in the claims below are intended to include any structure, material, or act for performing the function in combination with other claimed elements as specifically claimed. The description of the present invention has been presented for purposes of illustration and description, but is not intended to be exhaustive or limited to the invention in the form disclosed. Many modifications and variations will be apparent to those of ordinary skill in the art without departing from the scope and spirit of the invention. The embodiment was chosen and described in order to best explain the principles of the invention and the practical application, and to enable others of ordinary skill in the art to understand the invention for various embodiments with various modifications as are suited to the particular use contemplated.

## Claims

1. Method of controlled polymerization of a target zone in a photopolymerizable medium comprising:

    a processor connectable to an exposure system for illuminating a target zone in a photopolymerizable medium receiving a data representation of a 3D model of an object and using the 3D model to determine volume elements of the target zone, the volume defined by the volume elements in the medium being shaped according to the 3D model;
    the processor determining a target energy field $E_0$, the target energy field $E_0$ defining an energy to be absorbed by the volume elements of of the target zone to achieve polymerization inside the target zone, the determining by the processor being based on a model, preferably a reaction kinetic model or empirical model, of the polymerization process in the medium;
    the processor computing a direction-dependent optimal illumination field $I_o$ for depositing within an exposure time t the target energy field $E_0$ in the volume elements of the medium, the computing being based on a light propagation model $\mathcal{M}$ configured to predict the deposited energy field E in an attenuating medium, the deposited energy field E being generated upon exposure of the volume elements of the target zone to the direction-dependent illumination field $I$ during the exposure time t; and,
    the processor controlling the exposure system based on the direction-dependent illumination field $I_o$, the exposure including generating a plurality of direction-dependent illumination beams to deposit energy within the volume elements of the medium according to the target energy field $E_0$.

2. Method according to claim 1 wherein the computing further includes:

determining a solution $I_o$ for a system of equations of the type: $E_0 = t \cdot \mathcal{M} \cdot I_o,$ preferably the light propagation model $M$ being a model for predicting the deposited energy field E in an attenuating medium.

3. Method according to claim 1 wherein the computing further includes:

iteratively determining an approximate solution $I_o$ based on the light propagation model $\mathcal{M}$, the computing including minimizing a difference between the target energy field $E_0$ and a deposited energy field E predicted by the light propagation model $\mathcal{M}$, preferably the light propagation model $\mathcal{M}$ being a model for predicting the deposited energy field E in an attenuating medium.

4. Method according to any of claims 1-3, wherein the medium includes a photo-activation compound, preferably a photo-initiator and, optionally, a photosensitizer, for activating polymerization of the medium and a photo-deactivation compound, preferably a photo-inhibitor, for deactivating polymerization in the medium; and wherein computing a direction-dependent optimal illumination field $I_o$ further includes:

computing at least a first illumination field $I_+$ associated with a first wavelength and a second illumination field $I_-$ associated with a second wavelength, the second wavelength being different from the first wavelength, the first illumination field $I_+$ being configured to deposit within an exposure time t a first deposited energy $E_+$ in the volume elements of the medium for activating and maintaining polymerization in at least part of the target zone and the second illumination field $I_-$ being configured to deposit within an exposure time t a second deposited energy $E_-$ in the volume elements of the medium for deactivation of polymerization in at least part of the target zone.

5. Method according to claim 4 wherein the model is a linear approximation of the type: $E_0 = E_+ - \beta \cdot E_-$ wherein $\beta$ is a proportionality constant; $E_0 > E_{crit}$ inside the target zone and $E_0 < E_{crit}$ outside the target zone and $E_{crit}$ being a critical energy needed to achieve polymerization.

6. Method according to claims 1 or 2 wherein the solution $I_o$ includes a Fourier filter applied to the Radon transform of the target deposited energy, preferably the solution having the form $I_o = \frac{1}{\mu_+ t} \mathcal{F}\mathcal{R}[E_0].$

7. Method according to any of claims 1-6 wherein generating a plurality of direction-dependent illumination beams includes:

the processor controlling a rotatable and/or movable illumination system, the illumination system including at least one pixelated spatial light modulator for generating the plurality of direction-dependent illumination beams.

8. Method according to any of claims 1-7 the method further comprising:

the processor controlling a detection system to measure the intensity of a part of the plurality of illumination beams that was not absorbed by the medium, preferably the processor using the intensity of the part of the plurality of illumination beams that was not absorbed to compute the absorptivity of the medium $\mu$ during exposure.

9. Method according to claim 8 the method further comprising:

recomputing the direction-dependent optimal illumination field $I_o$ based on the target energy field $E_0$, the light propagation model $\mathcal{M}$ and the computed absorptivity $\mu$ of the medium; and, the processor controlling the exposure system based on the recomputed optimal direction-dependent illumination field $I_o$.

10. Method according to any of claims 1-9 wherein the system for illuminating a target zone comprising a container enclosing a photopolymerizable medium and a rotatable and/or movable illumination system, the illumination system including an optical system comprising light sources and optical elements, light modulating apertures and a support structure including motors and/or actuators configured to rotate and/or move the illumination system around the container while locally exposing the medium to light of at least one predetermined wavelength.

**11.** An exposure system adapted to photopolymerize a target zone in a photopolymerizable medium comprising:

a computer connectable to a rotatable illumination system for exposing the photopolymerizable medium, the computer comprising a computer readable storage medium having at least part of a program embodied therewith; and a processor, preferably a microprocessor, coupled to the computer readable storage medium, wherein responsive to executing the computer readable program code, the processor is configured to perform executable operations comprising:

receiving a data representation of a 3D model of an object and using the 3D model to determine volume elements of the target zone, the volume defined by the volume elements in the medium being shaped according to the 3D model;

determining a target energy field $E_0$, the target energy field $E_0$ defining an energy to be absorbed by the volume elements of of the target zone to achieve polymerization inside the target zone, the determining by the processor being based on a model, preferably a reaction kinetic model or empirical model, of the polymerization process in the medium;

computing a direction-dependent optimal illumination field $I_o$ for depositing within an exposure time t the target energy field $E_0$ in the volume elements of the medium, the computing being based on a light propagation model $M$ configured to predict the deposited energy field E in an attenuating medium, the deposited energy field E being generated upon exposure of the volume elements of the target zone to the direction-dependent illumination field $I$ during the exposure time t; and,

controlling the exposure system based on the direction-dependent illumination field $I_o$, the exposure including generating a plurality of direction-dependent illumination beams to deposit energy within the volume elements of the medium according to the target energy field $E_0$.

**12.** An exposure system according to claim 11 wherein the computing further includes:

determining a solution $I_o$ for a system of equations of the $$E_0 = \mathcal{M}\left(I_o, t\right),$$ preferably for a system of equations of the type: $E_0 = t \cdot \mathcal{M} \cdot I_o,$ preferably the light propagation model $\mathcal{M}$ being a model for predicting the deposited energy field E in a weakly attenuating medium, more preferably the solution $I_o$ including a Fourier

filter applied to the Radon transform of the target deposited energy: $$I_o = \frac{1}{\mu_+ t} \mathcal{FR}[E_0].$$

**13.** An exposure system according to claim 11 wherein the computing further includes:

iteratively determining an approximate solution $I_o$ based on the light propagation model $\mathcal{M}$, the computing including minimizing a difference between the target energy field $E_0$ and a deposited energy field E predicted by the light propagation model $\mathcal{M}$, preferably the light propagation model $\mathcal{M}$ being a model for predicting the deposited energy field E in a medium attenuating medium.

**14.** An exposure system according to any of claims 11-13, wherein the medium includes a photo-activation compound, preferably a photo-initiator and, optionally, a photosensitizer, for activating polymerization of the medium and a photo-deactivation compound, preferably a photo-inhibitor, for deactivating polymerization in the medium; and wherein computing a direction-dependent optimal illumination field $I_o$ further includes:

computing at least a first illumination field $I_+$ associated with a first wavelength and a second illumination field $I_-$ associated with a second wavelength, the second wavelength being different from the first wavelength, the first illumination field $I_+$ being configured to deposit within an exposure time t a first deposited energy $E_+$ in the volume elements of the medium for activating and maintaining polymerization in at least part of the target zone and the second illumination field $I_-$ being configured to deposit within an exposure time t a second deposited energy $E_-$ in the volume elements of the medium for deactivation of polymerization in at least part of the target zone.

**15.** An exposure system according to any of claims 11-14 wherein the system for illuminating a target zone comprises a container enclosing a photopolymerizable medium and a rotatable and/or movable illumination system, the illumination system including an optical system comprising light sources and optical elements, light modulating apertures and a support structure including motors and/or actuators configured to rotate and/or move the illumination system around the container while locally exposing the medium to light of at least one predetermined wavelength.

FIG. 1

**FIG. 2**

EP 3 627 227 A1

FIG. 3A

FIG. 3B

FIG. 3C

FIG. 3D

FIG. 3E

FIG. 4A

FIG. 4B

FIG. 4C

FIG. 4D

a processor connectable to an exposure system for illuminating a target zone in a polymerizable medium receiving a 3D data representation of a 3D model of an object and using the 3D model to determine a volume of the target zone, the volume being shaped according to the 3D model

502

the processor determining a target energy field $E_0$ defining an energy for volume elements in the medium that is needed to achieve polymerization inside the target zone, the determining being based model of the polymerization process in the medium, preferably the model being a linear approximation of the type: $E_0 = E_+ - \beta \cdot E_- > E_{crit}$

504

the processor using the target energy field $E_0$ and a light propagation model $\mathcal{M}$ for a weakly attenuating medium to compute a solution $I_o$ for the equation $E_0 = t \cdot \mathcal{M} \cdot I_o$ wherein $I_o$ is a direction-dependent illumination field for achieving energy deposition in the medium according to the target energy field and $t$ is the exposure time, preferably the solution including a filtered Radon transform of the target deposited energy: $I_o = \frac{1}{\mu_+ t} \mathcal{FR}[E_0]$

506

the processor controlling the exposure system based on the direction-dependent illumination field $I_o$, the exposure including generating a plurality of direction-dependent illumination beams to deposit energy within the target zone according to the target energy field $E_0$

510

# FIG. 5

FIG. 6A

FIG. 6C

FIG. 6B

FIG. 6D

EP 3 627 227 A1

a computer connectable to an exposure system for illuminating a target zone in a polymerizable medium receiving a 3D data representation of a 3D model of an object and using the 3D model to determine a volume of the target zone, the volume being shaped according to the 3D model, the computer determining a target energy field $E_0$ defining an energy for volume elements in the medium that is needed to achieve polymerization inside the target zone            702

determining an initial guess for a direction-dependent illumination field $I_o$ for achieving energy deposition in the medium according to the target energy field, the determining being based model of the polymerization process in the medium

703

computing a predicted deposited energy field $E$ using a light propagation model $\mathcal{M}$ with attenuation: $E = t \cdot \mathcal{M} I_0$, where $\mathcal{M} = \mu \cdot \widetilde{\mathcal{R}}^*$

704

computing an update $I'_0$ the direction dependent illumination field based on a difference between the predicted deposited energy field and a target energy field: $I'_0 = I_0 - \alpha \cdot \mathcal{M}^* (E - E_0)$ wherein $\mathcal{M}^*$ is an adjoint version of $\mathcal{M}$

708

710            setting new illumination intensity field $I_0 = I'_0$

NO

712  stopping criterion: e.g., $\sum (E - E_0)^2 < \epsilon$

YES

the computer controlling the exposure system based on the direction-dependent illumination field $I_o$, the exposure including generating a plurality of direction-dependent illumination beams to deposit energy within the target zone according to the target energy field $E_0$

714

# FIG. 7

FIG. 8A

FIG. 8B

FIG. 8C

FIG. 8D

FIG. 9

**FIG. 10**

Europäisches
Patentamt

European
Patent Office

Office européen
des brevets

**EUROPEAN SEARCH REPORT**

Application Number

EP 18 19 6384

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| E | WO 2018/208378 A2 (L LIVERMORE NAT SECURITY LLC [US]) 15 November 2018 (2018-11-15) * paragraphs [0022] - [0032]; claims 1-24; figures 3,4 * ----- | 1-3,6,7, 10-13,15 | INV. G03F7/20 B29C64/393 |
| A | Brett Kelly ET AL: "Computed Axial Lithography (CAL): Toward Single Step 3D Printing of Arbitrary Geometries", , 16 May 2017 (2017-05-16), XP55531615, Retrieved from the Internet: URL:https://arxiv.org/pdf/1705.05893.pdf * 5 CAL 3D Printing 6 Discussion/Future Work; figure 17 * ----- | 1-15 | |
| A | US 2018/086007 A1 (HENSLEIGH RYAN [US] ET AL) 29 March 2018 (2018-03-29) * paragraphs [0021] - [0024]; figure 1 * ----- | 1,4,5,14 | |
| A | US 2012/092632 A1 (MCLEOD ROBERT R [US] ET AL) 19 April 2012 (2012-04-19) * paragraph [0058]; claims 1-11 * ----- | 4,5,14 | TECHNICAL FIELDS SEARCHED (IPC) G03F B29C |
| A | US 2018/153205 A1 (WU XIANG [CN]) 7 June 2018 (2018-06-07) * the whole document * ----- | 1-15 | |

The present search report has been drawn up for all claims

| Place of search | Date of completion of the search | Examiner |
|---|---|---|
| Munich | 15 March 2019 | Angioni, Catherine |

EPO FORM 1503 03.82 (P04C01)

### ANNEX TO THE EUROPEAN SEARCH REPORT
### ON EUROPEAN PATENT APPLICATION NO.

EP 18 19 6384

This annex lists the patent family members relating to the patent documents cited in the above-mentioned European search report.
The members are as contained in the European Patent Office EDP file on
The European Patent Office is in no way liable for these particulars which are merely given for the purpose of information.

15-03-2019

| Patent document cited in search report | | Publication date | Patent family member(s) | | Publication date |
|---|---|---|---|---|---|
| WO 2018208378 | A2 | 15-11-2018 | US 2018326666 A1 | | 15-11-2018 |
| | | | WO 2018208378 A2 | | 15-11-2018 |
| US 2018086007 | A1 | 29-03-2018 | NONE | | |
| US 2012092632 | A1 | 19-04-2012 | NONE | | |
| US 2018153205 | A1 | 07-06-2018 | CN 108604047 A | | 28-09-2018 |
| | | | EP 3333629 A1 | | 13-06-2018 |
| | | | US 2018153205 A1 | | 07-06-2018 |
| | | | WO 2016173474 A1 | | 03-11-2016 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- One-step volumetric additive manufacturing of complex polymer structures. *Science Advances,* 08 December 2017, vol. 3 (12
- One-step volumetric additive manufacturing of complex polymer structures. *Science Advances,* 08 December 2017, vol. 3

- **HERMAN, G. T.** Fundamentals of computerized tomography: Image re- construction from projection. Springer, 2009
- 3D spectral imaging with synchrotron Fourier transform infrared spectro-microtomography. *Nature Methods,* 2013, vol. 10, 861864